# EUROPEAN PATENT SPECIFICATION

(11) **EP 3 410 346 B1**
(45) Date of publication and mention of the grant of the patent: **26.01.2022**
(21) Application number: 18173522.6
(22) Date of filing: 22.05.2018
(51) Int. Cl.: G06K 9/00

(54) **OLED PANEL**
OLED-PANEL
PANNEAU OLED

(30) Priority: 31.05.2017 CN 201710398562
(43) Date of publication of application: 05.12.2018
(73) Proprietor: Beijing Xiaomi Mobile Software Co., Ltd., Beijing 100085 (CN)
(72) Inventor: HE, Quanhua, Beijing, 100085 (CN)
(74) Representative: Hughes, Andrea Michelle

(56) References cited:
- WO-A1-2016/122173
- CN-A- 106 446 846
- US-A1- 2016 107 194
- US-A1- 2017 147 850

## Description

### FIELD

The present disclosure relates to the field of electronic technology, and more particularly, to an Organic Light-Emitting Diode (OLED) panel.

### BACKGROUND

The fingerprints of different users are different. As a result, with the continuous development of electronic technology, the fingerprint recognition technology has been more widely used in order to ensure the safety of user identity, for example, it can be used in the scenarios requiring authentication such as bank payment, and application unlock.

A terminal usually performs fingerprint recognition by the physical key of its panel, wherein the physical key can be configured with sensors for fingerprint recognition to recognize a user's fingerprint.

US 2016/107194 A1 discloses an ultrasonic sensor and display array

### SUMMARY

In order to solve the problem in related arts, an OLED panel for fingerprint recognition is provided by the present disclosure.

According to the present disclosure, an Organic Light-Emitting Diode (OLED) panel is provided, as claimed in claim 1.

deleted

deleted

deleted

deleted

deleted.

Alternatively, the ultrasonic transmitting unit and the ultrasonic receiving unit form a portion of a detection circuit for an ultrasonic biometric sensor.

Alternatively, the ultrasonic biometric sensor is a fingerprint sensor or a palm-print sensor.

Alternatively, the fingerprint sensor is configured to simultaneously recognize fingerprints from at least two fingers.

Alternatively, at least one of the ultrasonic emitting layer and the plurality of receivers is made of piezoelectric material.

deleted

deleted

deleted

deleted

deleted

deleted

Solutions provided by embodiments of the present disclosure may have the following beneficial effects: in embodiments of the present disclosure, when detecting a touch operation for fingerprint recognition, the terminal may emit the ultrasonic waves by the ultrasonic emitting layer in the ultrasonic transmitting unit included in the mounted OLED panel and detect the reflected waves of the ultrasonic waves by the plurality of receivers in the ultrasonic receiving unit included in the OLED panel. Next, the fingerprint image may be determined based on the time when the plurality of receivers detect the reflected waves and the intensities of the reflected waves. In embodiments of the present disclosure, the terminal may perform the fingerprint recognition by the ultrasonic emitting layer and the plurality of receivers located in the display area of the OLED panel without adding additional physical key to the OLED panel, so as to avoid the additional occupancy of the physical key on the OLED panel and increase the area of the OLED panel occupied by the screen, thereby increasing the screen-to-body ratio of the terminal and improving its display performance.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a structure diagram illustrating a first exemplary OLED panel according to an exemplary embodiment;
Fig. 2 is a structure diagram illustrating a substrate according to an exemplary embodiment;
Fig. 3 is a structure diagram illustrating an exemplary OLED pixel array according to an exemplary embodiment;
Fig. 4 is a structure diagram illustrating an exemplary ultrasonic transmitting unit according to an exemplary embodiment;
Fig. 5 is a structure diagram illustrating an exemplary ultrasonic receiving unit according to an exemplary embodiment;
Fig. 6A is a structure diagram illustrating a second exemplary OLED panel according to an exemplary embodiment;
Fig. 6B is a structure diagram illustrating an OLED panel shown for background purposes and is not covered by the claimed invention;
Fig. 6C is a structure diagram illustrating a fourth exemplary OLED panel shown for background purposes and is not covered by the claimed invention;
Fig. 7A is a structure diagram illustrating an OLED panel shown for background purposes and is not covered by the claimed invention;
Fig. 7B is a structure diagram illustrating a sixth exemplary OLED panel according to an exemplary embodiment;
Fig. 8 is a flow diagram illustrating a method for fingerprint recognition according to an exemplary embodiment;
Fig. 9 is a block diagram illustrating a device for fingerprint recognition according to an exemplary embodiment; and
Fig. 10 is a block diagram illustrating another device for fingerprint recognition according to an exemplary embodiment.

### DETAILED DESCRIPTION

Reference will now be made in detail to exemplary embodiments, examples of which are illustrated in the accompanying drawings. The following description refers to the accompanying drawings in which same numbers in different drawings represent same or similar elements unless otherwise described. The implementations set forth in the following description of exemplary embodiments do not represent all implementations consistent with the present disclosure. Instead, they are merely examples of devices and methods consistent with aspects related to the present disclosure as recited in the appended claims.

The application scenarios of the embodiments of the present disclosure will be described before explaining in detail the embodiments of the present disclosure. In order to ensure the safety of user identity, the fingerprint recognition technology has been more and more widely used in bank payment, application unlock and other scenarios requiring authentication. At present, a terminal usually perform the fingerprint recognition by the physical key of its panel, thus the physical key can be configured with sensors for fingerprint recognition to recognize a user's fingerprint. In order to facilitate the user to press for fingerprinting, and in order to recognize the fingerprint more accurately, the size of the physical key is usually very large, in which case the physical key occupies a large area of the panel and the screen occupies a small area of the panel, which causes a low screen-to-body ratio and a low display performance of the terminal. Therefore, an OLED panel is provided by the embodiments of the present disclosure to increase the screen-to-body ratio and display performance of the terminal.

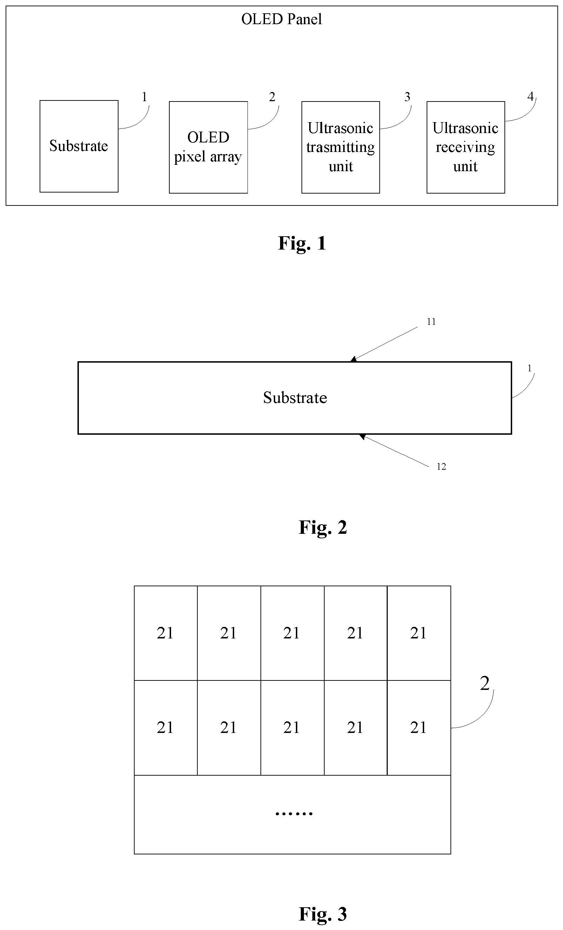

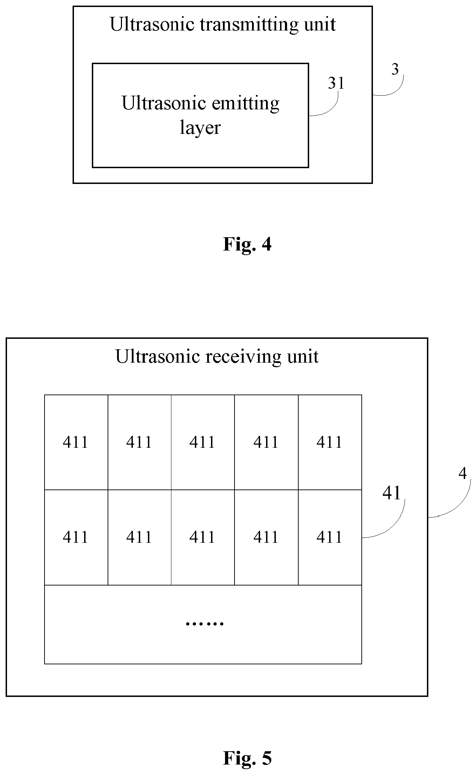

Fig. 1 is a structure diagram of an OLED panel according to an exemplary embodiment. As shown in Fig. 1, the OLED panel includes a substrate 1, an OLED pixel array 2, an ultrasonic transmitting unit 3, and an ultrasonic receiving unit 4, wherein:
as shown in Fig. 2, the substrate 1 has a first surface 11 and a second surface 12 which is configured to be opposite to the first surface 11;
as shown in Fig. 3, the OLED pixel array 2, which is located on the first surface 11 of the substrate 1, comprises a plurality of OLED sub-pixels 21;
as shown in Fig. 4, the ultrasonic transmitting unit 3 includes an ultrasonic emitting layer 31 for emitting ultrasonic waves;
as shown in Fig. 5, the ultrasonic receiving unit 4 includes a receiver array 41, the receiver array 41 comprising a plurality of receivers 411 for converting received ultrasonic waves into electrical signals;
wherein at least a part of orthographic projection of the ultrasonic emitting layer 31 and the receiver array 41 on a plane which the OLED pixel array 2 is located in falls within the OLED pixel array 2.

It should be noted that the OLED pixel array 2 is used for displaying a picture and the OLED pixel array 2 includes a plurality of pixels each including a plurality of OLED sub-pixels capable of emitting different colored light. For example, each pixel may include a sub-pixel R capable of emitting red light, a sub-pixel G capable of emitting green light, and a sub-pixel B capable of emitting blue light.

In addition, in order to ensure the accuracy for handprint recognition, such as fingerprint recognition, palm-print recognition, etc., the size of the plurality of receivers 411 may be configured to be small, such as 40 microns, 50 microns, etc.

Further, at least one of the ultrasonic emission layer 31 and the plurality of receivers 411 may be made of piezoelectric material, which may be Polyvinylidene Fluoride (PVDF), Lead Zirconate Titanate (PZT), and the like.

It should be noted that the orthographic projection of the ultrasonic emitting layer 31 and the receiver array 41 on the plane in which the OLED pixel array 2 is located may be partially or entirely falls within the OLED pixel array 2, wherein the ultrasonic emitting layer 31, the receiver array 41 and the OLED pixel array 2 are located in the same area of the OLED panel. Since the OLED pixel array 2 is located in a display area of the OLED panel for displaying a picture, the ultrasonic emitting layer 31 and the receiver array 41 are also located in the display area of the OLED panel.

When recognizing the handprint such as fingerprint, palm-print and the like, the terminal in which the OLED panel is mounted may perform the recognition by the ultrasonic emitting layer 31 and the receiver array 41 located in the display area of the OLED panel directly without adding additional physical key to the OLED panel, so as to avoid the additional occupancy of the physical key on the OLED panel and increase the area of the OLED panel occupied by the screen, thereby increasing the screen-to-body ratio of the terminal and improving its display performance.

It should be noted that the ultrasonic transmitting unit 3 and the ultrasonic receiving unit 4 are configured to form a portion of a detection circuit for an ultrasonic biometric sensor, and then the ultrasonic transmitting unit 3 and the ultrasonic receiving unit 4 can detect biological features such as fingerprint, palm-print and the like by ultrasonic waves.

The ultrasonic biometric sensor implements biological feature recognition with ultrasonic, for example, the ultrasonic biometric sensor can be a fingerprint sensor, a palm-print sensor and the like. And when the ultrasonic biometric sensor is a fingerprint sensor, the fingerprint sensor can be configured to simultaneously recognize fingerprints from at least two fingers, since the ultrasonic emitting layer 31 and the receiver array 41 are both located in the display area of the OLED panel and the display area of the OLED panel is generally large.

The position of the ultrasonic emitting layer 31 included in the ultrasonic transmitting unit 3 will be described below.

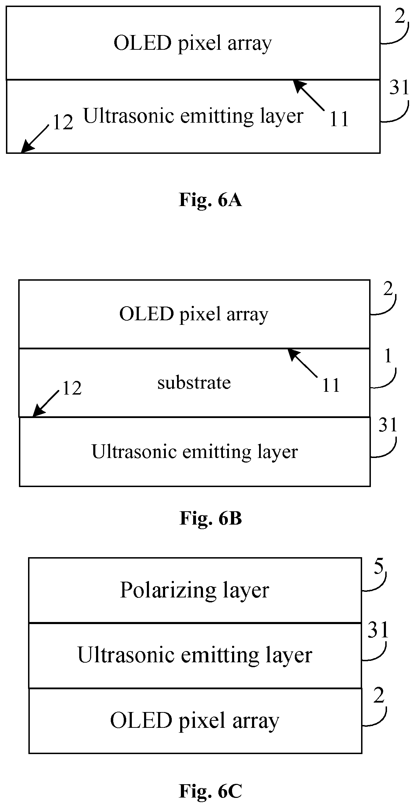

Referring to Fig. 6A, the ultrasonic emitting layer 31 is the substrate 1, wherein the ultrasonic emitting layer 31 has a first surface 11 and a second surface 12, and the OLED pixel array 2 is located on the first surface 11 of the ultrasonic emitting layer 31.

It should be noted that the polarizing layer 5 serves to reduce the reflected light of the OLED panel, enhance the visibility of the pictures displayed by the OLED panel, and improve display contrast.

Deleted.

The position of the receiver array 41 included in the ultrasonic receiving unit 4 will be described below.

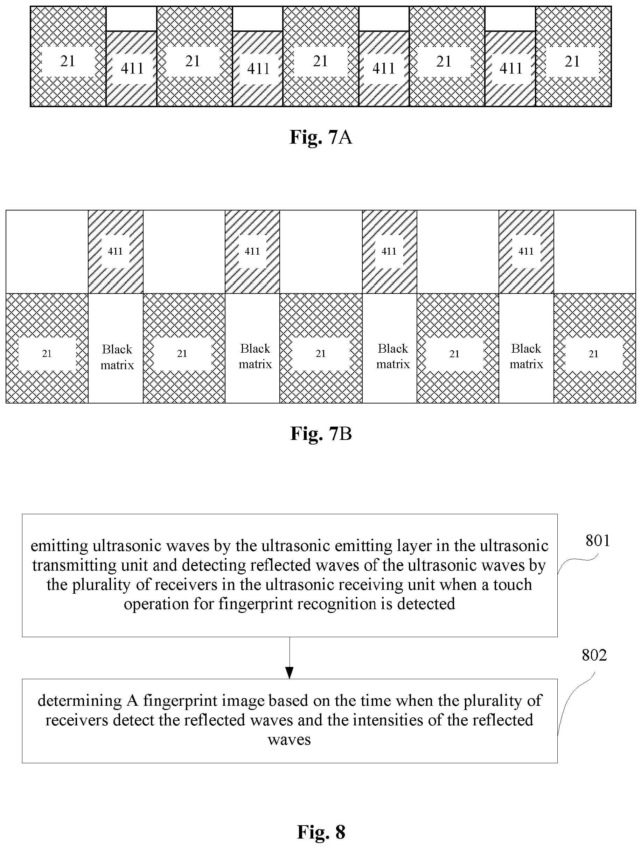

Referring to Fig. 7B, the plurality of receivers 411 are located on black matrixes between the plurality of OLED sub-pixels 21.

Deleted.

The plurality of receivers 411 may be separately added or may be located in the original protective layer on the black matrix, wherein the protective layer is the original protective layer between the polarizing layer 5 and the OLED pixel array 2.

In embodiments of the present disclosure, the OLED panel includes a substrate, an OLED pixel array, an ultrasonic transmitting unit, and an ultrasonic receiving unit. Since the ultrasonic emitting layer included in the ultrasonic transmitting unit and the receiver array included in the ultrasonic receiving unit are both located in the display area of the OLED panel, when recognizing the handprint such as fingerprint, palm-print and the like, the terminal in which the OLED panel is mounted may perform the recognition by the ultrasonic emitting layer and the receiver array located in the display area of the OLED panel directly without adding additional physical key to the OLED panel, so as to avoid the additional occupancy of the physical key on the OLED panel and increase the area of the OLED panel occupied by the screen, thereby increasing the screen-to-body ratio of the terminal and improving its display performance.

Fig. 8 is a flow diagram illustrating a method for fingerprint recognition according to an exemplary embodiment, and the method is applied to a terminal in which the OLED panel shown in any one of the above described Figs. 1 to 7B is mounted. Referring to Fig. 8, the method comprises the following steps.

In step 801, when a touch operation for fingerprint recognition is detected, ultrasonic waves are emitted by the ultrasonic emitting layer in the ultrasonic transmitting unit, and reflected waves of the ultrasonic waves are detected by the plurality of receivers in the ultrasonic receiving unit.

When the touch operation for fingerprint recognition is detected, it indicates that a user's finger is approaching the OLED panel, then the fingerprint recognition can be performed by the ultrasonic transmitting unit and the ultrasonic receiving unit.

In step 802, a fingerprint image is determined based on the time when the plurality of receivers detect the reflected waves and the intensities of the reflected waves.

Due to the different reflecting times of the finger and the air between the finger and the OLED panel for the ultrasonic waves, and the reflected waves with diffident intensities formed after the ultrasonic wave being reflected by the ridges and valleys of the fingerprint of the finger, it is possible to determine, based on the time when the reflected waves arc detected by the plurality of receivers and the intensities of the reflected waves, the positions of the ridges and valleys in the fingerprint image. After the ridges and valleys in the fingerprint image are determined, the fingerprint image can be obtained.

It should be noted that the ridges in the fingerprint of a finger are the convex parts on the epidermis of the fingerprint, and the valleys of the fingerprint are the concave parts on the epidermis of the fingerprint.

When the fingerprint image is determined based on the time when the reflected waves are detected by the plurality of receivers and the intensities of the reflected waves, it's possible to determine, for each of the plurality of receivers, a target reflected wave from the reflected waves detected by the receiver, wherein the time when the target reflected wave is detected by the receiver is within a preset time period. When the intensity of the target reflected wave is within the first preset intensity range, it's determined that the position of the receiver corresponds to a ridge position in the fingerprint image; and when the intensity of the target reflected wave is within the second preset intensity range, it is determined that the position of the receiver corresponds to a valley position in the fingerprint image.

It should be noted that the preset time period, the first preset intensity range, and the second preset intensity range can be set in advance, which will not be limited in the present disclosure.

In addition, when the time at which the target reflected wave is detected by the receiver is within the predetermined time period, it indicates that the target reflected wave is a reflected wave formed by the ultrasonic wave reflected by the finger. Therefore, the ridge position and the valley position in the fingerprint image can be determined based on the intensity of the target reflected wave.

Further, when the intensity of the target reflected wave is within the first preset intensity range, it is indicated that the target reflected wave is formed by the ultrasonic wave reflected by the ridge of the fingerprint, and the position of the receiver may correspond to the position of the ridge in the fingerprint image. And when the intensity of the target reflected wave is within the second preset intensity range, it is indicated that the target reflected wave is formed by the ultrasonic wave reflected by the valley of the fingerprint, and the position of the receiver may correspond to the position of the valley in the fingerprint image.

In embodiments of the present disclosure, when detecting a touch operation for fingerprint recognition, the terminal may emit the ultrasonic waves by the ultrasonic emitting layer in the ultrasonic transmitting unit included in the mounted OLED panel and detect the reflected waves of the ultrasonic waves by the plurality of receivers in the ultrasonic receiving unit included in the OLED panel. Next, the fingerprint image may be determined based on the time when the reflected waves are detected by the plurality of receivers and the intensities of the reflected waves. In embodiments of the present disclosure, the terminal may perform the fingerprint recognition by the ultrasonic emitting layer and the plurality of receivers located in the display area of the OLED panel without adding additional physical key to the OLED panel, so as to avoid the additional occupancy of the physical key on the OLED panel and increase the area of the OLED panel occupied by the screen, thereby increasing the screen-to-body ratio of the terminal and improving its display performance.

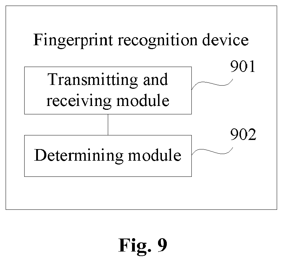

Fig. 9 is a block diagram illustrating a device for fingerprint recognition according to an exemplary embodiment, and the device includes the OLED panel shown in any one of the above described Figs. 1 to 7B. Referring to Fig. 9, the device includes a transmitting and receiving module 901 and a determining module 902.

The transmitting and receiving module 901 is used for, when a touch operation for fingerprint recognition is detected, emitting ultrasonic waves by the ultrasonic emitting layer in the ultrasonic transmitting unit and detecting reflected waves of the ultrasonic waves by the plurality of receivers in the ultrasonic receiving unit.

The determining module 902 determines the fingerprint image based on the time when the plurality of receivers detect the reflected waves and the intensities of the reflected waves.

Optionally, the determining module 902 includes:
a first determining sub-module for determining, for each of the plurality of receivers, a target reflected wave from the reflected waves detected by the receiver, wherein the time when the target reflected wave is detected by the receiver is within a preset time period;
a second determining sub-module for determining that the position of the receiver corresponds to the ridge position in the fingerprint image when the intensity of the target reflected wave is within a first preset intensity range;
a third determining sub-module for determining that the position of the receiver corresponds to the valley position in the fingerprint image when the intensity of the target reflected wave is within the second preset intensity range.

In the embodiments of the present disclosure, when detecting a touch operation for fingerprint recognition, the terminal may emit the ultrasonic waves by the ultrasonic emitting layer in the ultrasonic transmitting unit included in the mounted OLED panel and detect the reflected waves of the ultrasonic waves by the plurality of receivers in the ultrasonic receiving unit included in the OLED panel. Next, the fingerprint image may be determined based on the time when the reflected waves are detected by the plurality of receivers and the intensities of the reflected waves. In the embodiments of the present disclosure, the terminal may perform the fingerprint recognition by the ultrasonic emitting layer and the plurality of receivers located in the display area of the OLED panel without adding additional physical key to the OLED panel, so as to avoid the additional occupancy of the physical key on the OLED panel and increase the area of the OLED panel occupied by the screen, thereby increasing the screen-to-body ratio of the terminal and improving its display performance.

With respect to the devices in the above embodiments, the specific manners for performing operations for individual modules therein have been described in detail in the embodiments regarding the method, which will not be elaborated herein.

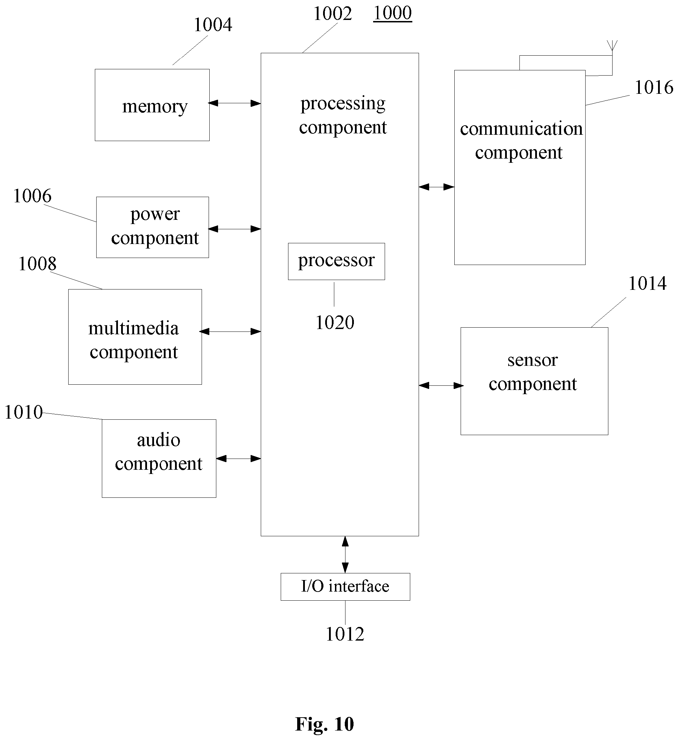

Fig. 10 is a block diagram illustrating a device 1000 for fingerprint recognition according to an exemplary embodiment. The device 1000 is equipped with an OLED panel shown in any one of the above-described Figs. 1 to 7B, for example, the device 1000 may be a mobile phone, a computer, a digital broadcast terminal, a message transceiver, a game console, a tablet device, a medical equipment, a fitness equipment, a personal digital assistant, and the like.

Referring to Fig. 10, the device 1000 may include one or more of the following components: a processing component 1002, a memory 1004, a power component 1006, a multimedia component 1008, an audio component 1010, an input/output (I/O) interface 1012, a sensor component 1014, and a communication component 1016.

The processing component 1002 typically controls overall operations of the device 1000, such as the operations associated with display, telephone calls, data communications, camera operations, and recording operations. The processing component 1002 may include one or more processors 1020 to execute instructions to perform all or part of the steps in the above described methods. Moreover, the processing component 1002 may include one or more modules which facilitate the interaction between the processing component 1002 and other components. For instance, the processing component 1002 may include a multimedia module to facilitate the interaction between the multimedia component 1008 and the processing component 1002.

The memory 1004 is configured to store various types of data to support the operation of the device 1000. Examples of such data may include instructions for any applications or methods operated on the device 1000, contact data, phonebook data, messages, pictures, video, etc. The memory 1004 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1006 provides power to various components of the device 1000. The power component 1006 may include a power management system, one or more power sources, and any other components associated with the generation, management, and distribution of power in the device 1000.

The multimedia component 1008 includes a screen providing an output interface between the device 1000 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also detect a period of time and a pressure associated with the touch or swipe action. In some embodiments, the multimedia component 1008 includes a front camera and/or a rear camera. The front camera and/or the rear camera may receive an external multimedia datum while the device 1000 is in an operation mode, such as a photographing mode or a video mode. Each of the front camera and the rear camera may be a fixed optical lens system or have focus and optical zoom capability.

The audio component 1010 is configured to output and/or input audio signals. For example, the audio component 1010 includes a microphone ("MIC") configured to receive an external audio signal when the device 1000 is in an operation mode, such as a call mode, a recording mode, and a voice recognition mode. The received audio signal may be further stored in the memory 1004 or transmitted via the communication component 1016. In some embodiments, the audio component 1010 further includes a speaker to output audio signals.

The I/O interface 1012 provides an interface between the processing component 1002 and peripheral interface modules, such as a keyboard, a click wheel, buttons, and the like. The buttons may include, but are not limited to, a home button, a volume button, a starting button, and a locking button.

The sensor component 1014 includes one or more sensors to provide status assessments of various aspects of the device 1000. For instance, the sensor component 1014 may detect an open/closed status of the device 1000, relative positioning of components, e.g., the display and the keypad, of the device 1000, a change in position of the device 1000 or a component of the device 1000, a presence or absence of user contact with the device 1000, an orientation or an acceleration/deceleration of the device 1000, and a change in temperature of the device 1000. The sensor component 1014 may include a proximity sensor configured to detect the presence of nearby objects without any physical contact. The sensor component 1014 may also include a light sensor, such as a CMOS or CCD image sensor, for use in imaging applications. In some embodiments, the sensor component 1014 may also include an accelerometer sensor, a gyroscope sensor, a magnetic sensor, a distance sensor, a pressure sensor, or a temperature sensor.

The communication component 1016 is configured to facilitate communication, wired or wirelessly, between the device 1000 and other devices. The device 1000 can access a wireless network based on a communication standard, such as WiFi, 2G, or 3G, or a combination thereof. In one exemplary embodiment, the communication component 1016 receives a broadcast signal or broadcast associated information from an external broadcast management system via a broadcast channel. In one exemplary embodiment, the communication component 1016 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 1000 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as the memory 1004 including instructions executable by the processor 1020 in the device 1000 to perform the above-described methods. For example, the non-transitory computer-readable storage medium may be a ROM, a RAM, a CD-ROM, a magnetic tape, a floppy disc, an optical data storage device, and the like.

In exemplary embodiments, there is also provided a non-transitory computer-readable storage medium including instructions that, when executed by a processor of a mobile terminal, enables the mobile terminal to perform the above-described method for fingerprint recognition.

Other embodiments of the disclosure will be apparent to those skilled in the art from consideration of the specification and practice of the disclosure disclosed here.

It is intended that the scope of the disclosure only be limited by the appended claims.

## Claims

1. An Organic Light-Emitting Diode, OLED, panel, comprising:
a substrate (1) having a first surface (11) and a second surface (12) that is opposite to the first surface; wherein the first surface (11) is an upper surface and the second surface (12) is a lower surface;
an OLED pixel array (2) located in a plane on the first surface of the substrate (1), the OLED pixel array (2) including a plurality of OLED sub-pixels (21);
an ultrasonic transmitting unit (3) including an ultrasonic emitting layer (31) configured to emit ultrasonic waves (31); and
an ultrasonic receiving unit (4) including a receiver array (41), the receiver array including a plurality of receivers (411) configured to convert received ultrasonic waves into electrical signals,
wherein the ultrasonic emitting layer (31), the receiver array (41), and the OLED pixel array (2) are located in the same area of the OLED panel;
wherein the ultrasonic emitting layer (31) is the substrate (1);
wherein a width of each of the plurality of receivers (411) is smaller than that of each of the plurality of OLED sub-pixels (21);
and the OLED pixel array (2) is on the first surface (11) of the ultrasonic emitting layer (31) and outside the ultrasonic emitting layer (31);
**characterized in that**
the plurality of receivers (411) are located on black matrixes between the plurality of OLED sub-pixels (21).

2. The OLED panel of claim 1, wherein the ultrasonic transmitting unit (3) and the ultrasonic receiving unit (4) form a portion of a detection circuit for an ultrasonic biometric sensor.

3. The OLED panel of claim 2, wherein the ultrasonic biometric sensor is a fingerprint sensor or a palm-print sensor.

4. The OLED panel of claim 3, wherein the fingerprint sensor is configured to simultaneously recognize fingerprints from at least two fingers.

5. The OLED panel of claim 1, wherein at least one of the ultrasonic emitting layer (31) and the plurality of receivers (411) is made of piezoelectric material.

## Patentansprüche

1. OLED-Panel, Panel aus organischen Licht emittierenden Dioden, umfassend:
ein Substrat (1), das eine erste Oberfläche (11) und eine zweite Oberfläche (12), die gegenüberliegend zu der ersten Oberfläche ist, aufweiset; wobei die erste Oberfläche (11) eine obere Oberfläche ist und die zweite Oberfläche (12) eine untere Oberfläche ist;
eine OLED-Pixelmatrix (2), die in einer Ebene auf der ersten Oberfläche des Substrats (1) gelegen ist, wobei die OLED-Pixelmatrix (2) eine Vielzahl von OLED-Subpixeln (21) einschließt;
eine Ultraschall übertragende Einheit (3), die eine Ultraschall emittierende Schicht (31) einschließt, die ausgelegt ist, um Ultraschallwellen (31) zu emittieren; und
eine Ultraschall empfangende Einheit (4), die eine Empfängermatrix (41) einschließt, wobei die Empfängermatrix eine Vielzahl von Empfängern (411) einschließt, die ausgelegt sind, um empfangene Ultraschallwellen in elektrische Signale umzuwandeln,
wobei die Ultraschall emittierende Schicht (31), die Empfängermatrix (41) und die OLED-Pixelmatrix (2) in dem gleichen Bereich des OLED-Panels gelegen sind;
wobei die Ultraschall emittierende Schicht (31) das Substrat (1) ist;
wobei eine Breite von jedem der Vielzahl von Empfängern (411) kleiner ist als die von jedem der Vielzahl von OLED Subpixeln (21);
und die OLED-Pixelmatrix (2) auf der ersten Oberfläche (11) der Ultraschall emittierenden Schicht (31) und außerhalb der Ultraschall emittierenden Schicht (31) liegt;
**dadurch gekennzeichnet, dass**
die Vielzahl von Empfängern (411) auf Black-Matrizes zwischen der Vielzahl von OLED Subpixeln (21) gelegen ist.

2. OLED-Panel nach Anspruch 1, wobei die Ultraschall übertragende Einheit (3) und die Ultraschall empfangende Einheit (4) einen Abschnitt einer Erkennungsschaltung für einen biometrischen Ultraschallsensor bilden.

3. OLED-Panel nach Anspruch 2, wobei der biometrische Ultraschallsensor ein Fingerabdrucksensor oder ein Handflächenabdrucksensor ist.

4. OLED-Panel nach Anspruch 3, wobei der Fingerabdrucksensor ausgelegt ist, um gleichzeitig Fingerabdrücke von mindestens zwei Fingern zu erkennen.

5. OLED-Panel nach Anspruch 1, wobei mindestens eines der Ultraschall emittierenden Schicht (31) und der Vielzahl von Empfängern (411) aus piezoelektrischem Material hergestellt ist.

## Revendications

1. Panneau à diodes électroluminescentes organiques, OLED, comprenant :
un substrat (1) présentant une première surface (11) et une seconde surface (12) qui est opposée à la première surface, dans lequel la première surface (11) est une surface supérieure et la seconde surface (12) est une surface inférieure ;
un réseau de pixels OLED (2) situé dans un plan sur la première surface du substrat (1), le réseau de pixels OLED (2) incluant une pluralité de sous-pixels OLED (21) ;
une unité de transmission d'ultrasons (3) incluant une couche d'émission d'ultrasons (31) conçue pour émettre des ondes ultrasonores (31) ; et
une unité de réception d'ultrasons (4) incluant un réseau de récepteurs (41), le réseau de récepteurs incluant une pluralité de récepteurs (411) conçus pour convertir des ondes ultrasonores reçues en signaux électriques,
dans lequel la couche d'émission d'ultrasons (31), le réseau de récepteurs (41) et le réseau de pixels OLED (2) sont situés dans la même zone du panneau OLED ;
dans lequel la couche d'émission d'ultrasons (31) est le substrat (1) ;
dans lequel une largeur de chacun de la pluralité de récepteurs (411) est plus petite que celle de chacun de la pluralité de sous-pixels OLED (21) ;
et le réseau de pixels OLED (2) est sur la première surface (11) de la couche d'émission d'ultrasons (31) et à l'extérieur de la couche d'émission d'ultrasons (31) ;
**caractérisé en ce que**
la pluralité de récepteurs (411) sont situés sur des matrices noires entre la pluralité de sous-pixels OLED (21).

2. Panneau OLED selon la revendication 1, dans lequel l'unité de transmission d'ultrasons (3) et l'unité de réception d'ultrasons (4) font partie d'un circuit de détection pour un capteur biométrique à ultrasons.

3. Panneau OLED selon la revendication 2, dans lequel le capteur biométrique à ultrasons est un capteur d'empreinte digitale ou un capteur d'empreinte palmaire.

4. Panneau OLED selon la revendication 3, dans lequel le capteur d'empreinte digitale est conçu pour reconnaître simultanément des empreintes digitales à partir d'au moins deux doigts.

5. Panneau OLED selon la revendication 1, dans lequel au moins un de la couche d'émission d'ultrasons (31) et de la pluralité de récepteurs (411) est constitué de matériau piézoélectrique.
